# EUROPÄISCHE PATENTSCHRIFT

(11) **EP 2 812 965 B1**
(45) Veröffentlichungstag und Bekanntmachung des Hinweises auf die Patenterteilung: **10.04.2019**
(21) Anmeldenummer: 13704716.3
(22) Anmeldetag: 07.02.2013
(51) Int. Cl.: H02B 1/052, F04D 25/08, F04D 29/60, H02B 1/56, F04D 19/00

(54) **LÜFTER UND ANORDNUNG AUFWEISEND EINEN DERARTIGEN LÜFTER**
FAN AND ASSEMBLY WITH SUCH A FAN
VENTILATEUR ET DISPOSITIF COMPRENANT UN TEL VENTILATEUR

(30) Priorität: 07.02.2012 DE 102012100974
(43) Veröffentlichungstag der Anmeldung: 17.12.2014
(73) Patentinhaber: STEGO-Holding GmbH, 74523 Schwäbisch Hall (DE)
(72) Erfinder: SCHANZENBACH, Bernd, Armin, 74535 Mainhardt Geisselhardt (DE)
(74) Vertreter: Bohnenberger, Johannes
(86) Internationale Anmeldenummer: PCT/EP2013/000370
(87) Internationale Veröffentlichungsnummer: WO 2013/117338

(56) Entgegenhaltungen:
- EP-A1- 1 542 324
- EP-A1- 2 118 968
- WO-A1-2010/100451
- DE-A1-102009 014 654
- DE-U1- 29 517 962
- JP-A- H07 162 167
- JP-A- 2008 177 597
- JP-A- 2009 290 018

## Beschreibung

Die Erfindung betrifft einen Lüfter und eine Anordnung aufweisend einen derartigen Lüfter. Die Befestigung des Lüfters beispielsweise in einem Schaltschrank erfolgt üblicherweise mittels einer Hutschiene. Eine für eine Hutschiene geeignete Befestigungseinrichtung ist im Zusammenhang mit Reiheneinbaugeräten in der DE 10 2007 015 470 A1 beschrieben.

Bei dieser Befestigungseinrichtung sind eine obere und eine untere Halteeinrichtung an einer Rückwand eines Gerätes vorgesehen. Zum Befestigen des Gerätes an der Hutschiene kippt man dieses nach oben, hängt die obere Halteeinrichtung in den Oberrand der Hutschiene ein und kippt dann das Gerät wieder nach unten, wobei die untere Halteeinrichtung in einen lösbaren Schnappeingriff mit dem Unterrand der Hutschiene gelangt. Zum Abbauen des Gerätes wird die untere Halteeinrichtung gelöst und das Gerät kann nach oben gekippt und abgenommen werden.

Dann, wenn ein Gerät eine sehr große Bautiefe aufweist, wie z.B. eine Belüftungs-, Beheizungs- oder Beleuchtungseinrichtung und der Einbauraum über der Hutschiene gering ist, gibt es Schwierigkeiten beim Befestigen des Gerätes an der Hutschiene, da ein Hochkippen nur in begrenztem Maße möglich ist. Darüber hinaus darf das Gerät bei der bekannten Befestigungseinrichtung nur eine begrenzte Bauhöhe aufweisen, ansonsten muss die Rückwand schräg ausgebildet werden, um den notwendigen Kippwinkel zu erzielen. Dies verringert den Einbauraum innerhalb des Gerätes.

JP 2009 290 018 A betrifft eine Struktur zum Montieren einer Schiene, die in der Lage ist, eine Struktur zum Montieren eines Gerätekörpers an einer Schiene an dem Gerätekörper einstückig auszubilden. In der Struktur zum Montieren der Schiene greifen die Eingriffsstückteile der Schiene in ein Paar Eingriffsnuten ein, wobei die Bewegung in der Vorne-Hinten-Richtung reguliert wird.

JP 2008 177 597 A bezieht sich auf ein auf Schienen montierbares elektronisches Gerät, das durch Drehen des elektronischen Geräts an einer Schiene angebracht wird. Zum Installieren des Geräts weist die Schiene ein Paar Verriegelungsteile auf, die mit einem Paar von Eingriffsmitteln des Geräts in Eingriff kommen.

JP H07 162 167 A beschreibt ein an einer Tragschiene installierbares elektrisches Gerät, das an beiden Seitenkanten eine an einer unteren Bodenfläche 1 des Geräts ausgebildete Schienenbefestigungs- und Einsetznut mit stützenden abgestuften Kanten und offenen Kanten aufweist.

DE 10 2009 014 654 A1 betrifft ein Ventilationssystem mit einem Adapter zum Anbringen an einer Profilträgerschiene. Der Ventilator ist drehbar am Adapter zum Einstellen einer Luftstromrichtung angebracht. Der Abstand zwischen dem Ventilator und dem Adapter ist zur Einstellung einer Luftstrom-Austrittsstelle des Ventilators einstellbar. Der Ventilator ist in einem Ventilatorgehäuse vorgesehen, und der Adapter ist beweglich am Ventilatorgehäuse angebracht, um die Luftstromrichtung einzustellen.

EP 2 118 968 B1 beschreibt einen elektrischen Anschlußblock mit einer Basis und vier oder mehr Nasen, die von einer flachen Unterseite nach unten vorstehen. Diese werden verwendet, um den Block gegen eine feste Halterung, wie eine DIN-Schiene mit komplanaren Kanten, in einer Ebene parallel zu der Unterseite des Blocks zu verriegeln.

Der Erfindung liegt die Aufgabe zu Grunde, einen Lüfter anzugeben, der einen geringen Einbauraum für die Montage/Demontage benötigt. Ferner soll eine Anordnung aufweisend einen derartigen Lüfter angegeben werden. Diese Aufgabe wird für den Lüfter durch den Gegenstand des Anspruchs 1 und für die Anordnung durch den Gegenstand des Anspruchs 10 gelöst.

Insbesondere wird diese Aufgabe durch einen Lüfter mit einer Düse gelöst, die an einer Grundplatte befestigt ist, wobei die Grundplatte an ihrer Rückwand eine Befestigungseinrichtung mit wenigstens einer oberen Halteeinrichtung und wenigstens einer unteren Halteeinrichtung zum Befestigen des Lüfters an einer Hutschiene aufweist. Die obere Halteeinrichtung und die untere Halteeinrichtung umgreifen im befestigten Zustand einen Oberrand bzw. einen Unterrand der Hutschiene. Die beiden Halteeinrichtungen sind versetzt zueinander angeordnet und zwar in einer Richtung, die im befestigten Zustand des Lüfters parallel zur Längsachse der Hutschiene verläuft. Die in dieser Richtung aufeinander zugewandten Enden der Halteeinrichtungen bilden Innenenden, wobei zwischen dem Innenende der oberen Halteeinrichtung und dem Innenende der unteren Halteeinrichtung ein Abstand von einer Breite liegt, die größer ist, als der Abstand zwischen dem Oberrand und dem Unterrand der Hutschiene, so dass der Lüfter durch Kippen in einer Einsetzkipprichtung um eine Kippachse senkrecht zu einer Hutschienenlängsrichtung in die Hutschiene einsetzbar ist, wobei die Düse mit der Grundplatte durch ein eindimensionales Schwenkelement zum Verschwenken des Lüfters um eine Schwenkachse verbunden ist, wobei die Rückwand der Düse konvex gekrümmt und in einer entsprechend konkav gekrümmten Vorderwand der Grundplatte aufgenommen ist, und wobei die Seitenwände und die Vorderwand der Grundplatte und die Rückwand der Düse Luftschlitze aufweisen.

Es wird also das bisher bekannte "Nach-Oben-Kippen" geändert in ein Kippen oder Drehen des Lüfters um eine Kippachse, die parallel liegt zur Längsachse des Lüfters oder mit dieser übereinstimmt. Dadurch ist es möglich, zum einen die Rückwand des Lüfters auch bei größerer Bauhöhe vollständig gerade, also ohne die sonst notwendige Abschrägung zu gestalten. Zum anderen ist der über der Hutschiene bzw. dem Lüfter notwendige Freiraum durch diese andersartige Einhängebewegung auch bei einer sehr großen Lüftertiefe erheblich geringer, als dies bisher der Fall war.

Dann, wenn der Lüfterschwerpunkt relativ zur Kippachse so liegt, dass der Lüfter im befestigten Zustand in Befestigungsrichtung verkippt wird, ist ein Einhängen und sicheres Befestigen des Lüfters an der Hutschiene ohne einen zusätzlichen Sperrriegel möglich. Um jedoch eine erhöhte Sicherheit zu bekommen, wird vorzugsweise ein Sperrriegel vorgesehen, der dem Lüfter im befestigten Zustand gegen das Kippen sperrt.

Der Sperrriegel ist vorzugsweise derart ausgebildet, dass er beim Einsetzen des Lüfters durch das Kippen in Einsetzkipprichtung entsperrbar ist. Er schnappt also ohne gesonderte Betätigung ein.

Bei einer bevorzugten Ausführungsform der Erfindung weisen die obere und die untere Halteeinrichtung einander zugewandte Abschrägungen zur Verminderung des zum Einsetzen notwendigen Kippwinkels auf.

Die obere und die untere Halteeinrichtung können verschieden lang sein, wobei die obere Halteeinrichtung vorzugsweise länger ist als die untere Halteeinrichtung. Vorzugsweise sind die beiden Halteeinrichtungen jedoch im Wesentlichen rotationssymmetrisch um die Kippachse ausgebildet.

Besonders einfach ist die Konstruktion dann, wenn die Halteeinrichtungen mit einer Rückwand des Lüfters einstückig ausgebildet, insbesondere aus Kunststoff, vorzugsweise spritzgegossen sind.

Die Befestigungseinrichtung kann mehrere obere Halteeinrichtungen und mehrere untere Halteeinrichtungen aufweisen, wobei die oberen und die unteren Halteeinrichtungen unterschiedlich orientiert sind und paarweise zum Befestigen des Lüfters an der Hutschiene derart zusammenwirken, dass der Lüfter in unterschiedlichen Positionen, bspw. in 90° zueinander versetzten Positionen montierbar ist. Vorteilhaft hieran ist, dass der Lüfter je nach den unterschiedlichen Anforderungen an seine Position technisch einfach flexibel montierbar ist. Ein weiterer Vorteil besteht darin, dass durch die Montage in unterschiedlichen Positionen, insbesondere in 90° zueinander versetzten Positionen der Anschluss des Lüfters variabel ist.

Erfindungsgemäss umfasst der Lüfter ein eindimensionales Schwenkelement zum Verschwenken des Lüfters um eine Schwenkachse. Hierdurch ist die Richtung der durch die Düse austretenden Luft technisch einfach verstellbar.

Der Lüfter kann in derartigen Positionen montierbar sein, dass die Schwenkachse im Wesentlichen parallel oder im Wesentlichen senkrecht zur Längsachse der Hutschiene verläuft. Hierdurch wird ein hoher Freiheitsgrad der Ausblasrichtung der Luft durch die Düse des Lüfters gewährleistet. Wenn der Lüfter zusätzlich über ein drehbares Ausblasgitter verfügt, ist es somit möglich, jede Richtung der Ausblasrichtung der Luft einzustellen. Durch die Möglichkeit, den Lüfter in zwei zueinander um 90° versetzten Positionen zu montieren, wird zur Erreichung eines hohen bzw. maximalen Freiheitsgrads der Ausblasrichtung der Luft nur ein eindimensionales Schwenkelement benötigt. Ein eindimensionales Schwenkelement, das in einer einzigen Ebene schwenkbar ist, weist, insbesondere gegenüber einem zweidimensionalen Schwenkelement, den Vorteil auf, dass dieses kostengünstig und stabil ist. Gleichzeitig wird durch die Kombination der Montierbarkeit in zwei zueinander um 90° versetzten Positionen, der Schwenkbarkeit bzw. Drehbarkeit um eine Schwenkachse sowie ggf. durch die Drehbarkeit des Ausblasgitters ein hoher bzw. maximaler Freiheitsgrad der Einstellbarkeit der Ausblasrichtung erreicht. Insbesondere ist der Lüfter mit einem eindimensionalen Schwenkelement gegenüber Vibrationskräften stabil bzw. bei auftretenden Vibrationskräften gegenüber einem zweidimensionalen Drehelement bzw. Schwenkelement stabiler, insbesondere wenn bei einem zweidimensionalen Drehelement bzw. Schwenkelement die zweite Drehachse bzw. Schwenkachse weiter von der Hutschiene, also dem Aufhängepunkt des Lüfters, entfernt ist.

In einer weiteren Ausführungsform sind die Halteeinrichtungen und/oder die Abschrägungen auf die Materialdicke der Hutschiene und/oder die Tiefe der Hutschiene angepasst. Vorteilhaft hieran ist, dass der Lüfter technisch einfach und sicher an entsprechend ausgebildeten Hutschienen befestigbar ist bzw. befestigt werden kann.

Im Rahmen der Anordnung aufweisend einen derartigen Lüfter und eine Hutschiene, wird die Kombination aus Lüfter und Hutschiene offenbart und beansprucht. Dabei ist der Lüfter durch die Befestigungseinrichtung mit der Hutschiene verbunden, insbesondere lösbar verbunden.

Nachfolgend werden bevorzugte Ausführungsformen der Erfindung anhand von Abbildungen näher erläutert. Hierbei zeigen
- Fig. 1: eine erste Ausführungsform einer Befestigungseinrichtung in einer Ansicht von hinten im befestigten Zustand, die für den erfindungsgemäßen Lüfter vorgesehen ist,
- Fig. 2: die Ausführungsform nach Fig. 1 beim Einsetzen,
- Fig. 3: eine Hutschiene sowie eine Befestigungseinrichtung von hinten gemäß einer zweiten Ausführungsform, die für den erfindungsgemäßen Lüfter vorgesehen ist,
- Fig. 4: die Anordnung nach Fig. 3 nach dem Befestigen,
- Fig. 5: eine Ansicht ähnlich der nach Fig. 4, jedoch in einem Zustand während des Einsetzens,
- Fig. 6: eine perspektivische Seitenansicht einer Ausführungsform des erfindungsgemäßen Lüfters,
- Fig. 7: Rückansicht des Lüfters nach Fig. 6, und
- Fig. 8A, 8B: schematische Seitenansichten verschiedener Arten von Hutschienen, an denen Ausführungsformen des erfindungsgemäßen Lüfters befestigt bzw. befestigbar sind.

In der nachfolgenden Beschreibung werden für gleiche und gleich wirkende Teile dieselben Bezugsziffern verwendet.

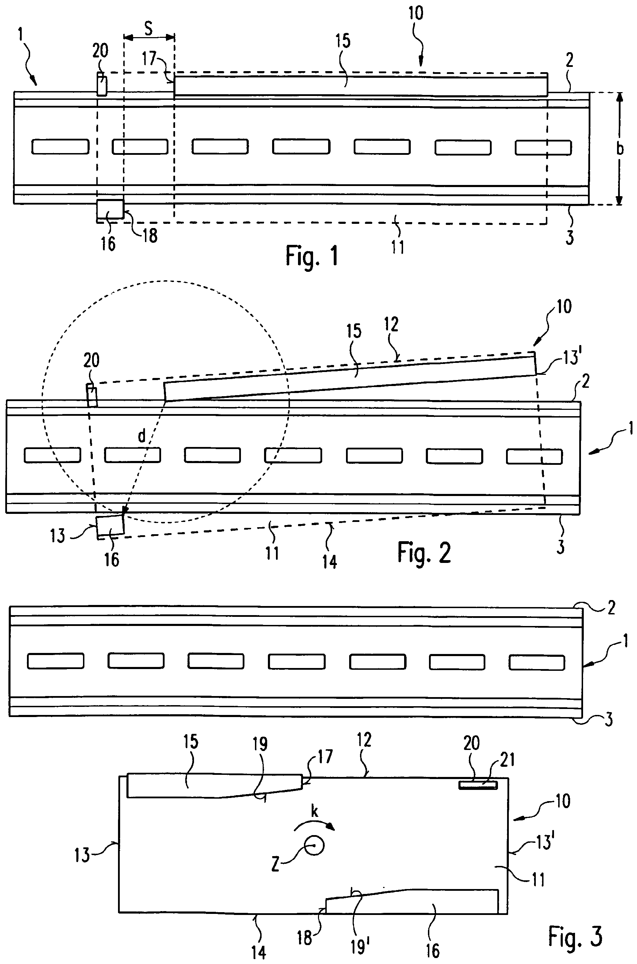

In Fig. 1 ist eine Hutschiene 1 mit ihrem Oberrand 2 und ihrem Unterrand 3 schematisiert dargestellt und zwar in einer Ansicht von hinten, also von der Seite aus, mit welcher die Hutschiene 1 in einem Schaltkasten oder dergleichen montiert wird.

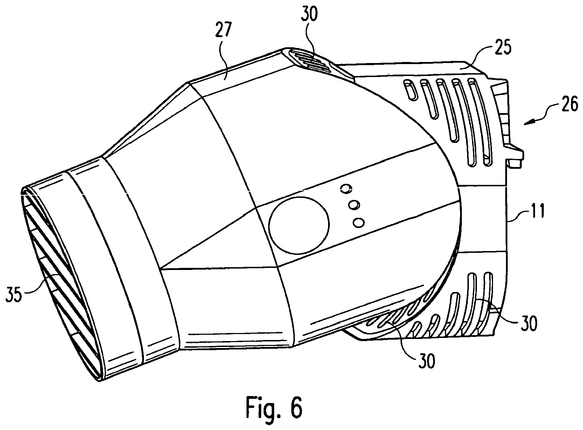

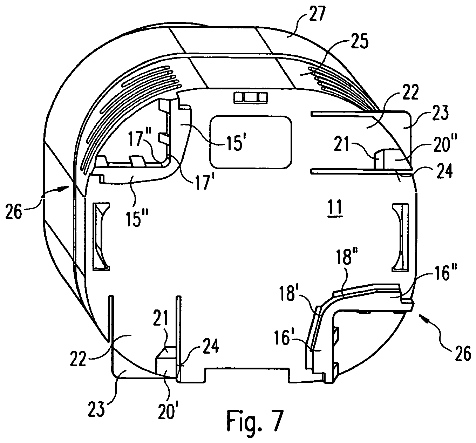

Die Befestigung des Lüfters 10 an der Hutschiene 1 wird nachfolgend in allgemeiner Weise in Zusammenhang mit einem Gerät 10 bzw. Körper erläutert. Die Konstruktionsmerkmale der Befestigungseinrichtung 26 sowie deren Funktionsweise werden im Zusammenhang mit einem Lüfter, der eine Düse aufweist, offenbart und beansprucht. Ein konkretes Ausführungsbeispiel für einen derartigen Lüfter ist in den Fig. 6, 7 offenbart.

An der Hutschiene 1 ist in dieser Darstellung ein Gerät 10 bzw. ein Körper befestigt, an dessen Rückwand 11 eine obere Halteeinrichtung 15 und eine untere Halteeinrichtung 16 befestigt sind, welche eine im Wesentlichen L-förmige Gestalt aufweisen, so dass sie den Oberrand 2 bzw. den Unterrand 3 der Hutschiene 1 umgreifen können. Ein Innenende 17 der oberen Halteeinrichtung 15 und ein Innenende 18 der unteren Halteeinrichtung 16 sind um einen Abstand S voneinander entfernt. Weiterhin ist ein Sperrriegel 20 vorgesehen, der zum Einschnappen über den Oberrand 2 der Hutschiene 1 ausgebildet ist, wie dies weiter unten näher beschrieben wird.

Wie in Fig. 2 gezeigt, führt der Abstand S zu einem Spalt zwischen dem Innenende 17 der oberen Halteeinrichtung 15 und dem Innenende 18 der unteren Halteeinrichtung 16, der in Fig. 2 mit d bezeichnet ist. Wenn man demzufolge den Körper 10 so wie in Fig. 2 gezeigt, entgegen dem Uhrzeigersinn kippt, so kann der Körper 10 mit seiner oberen Halteeinrichtung 15 und der unteren Halteeinrichtung 16 auf die Hutschiene 1 aufgesteckt werden, deren Breite b (siehe Fig. 1) geringer ist als dieser Abstand d. Wenn dann der Körper 10 wieder in die horizontale Lage (wie in Fig. 1 gezeigt) zurückgekippt wird, so schnappt der Sperrriegel 20 ein und überragt den Oberrand 2 der Hutschiene 1 derart, dass ein Kippen zum Abnehmen des Körpers von der Hutschiene 1 nicht mehr möglich ist.

Allgemein gesagt, sind die obere und die untere Halteeinrichtung 15, 16 versetzt zueinander angeordnet in einer Richtung, die im befestigten Zustand des Gerätes oder Körpers 10 parallel zur Längsachse der Hutschiene 1 verläuft, wobei die in dieser Richtung aufeinander zugewandten Enden der Halteeinrichtungen die Innenenden 17, 18 bilden. Dieses Merkmal wird im Zusammenhang mit allen Ausführungsbeispielen offenbart und beansprucht.

Die in Fig. 1 und 2 gezeigte Anordnung soll darstellen, dass es in erster Linie auf eine korrekte Bemessung des Abstands S in Relation zur Breite b der Hutschiene ankommt, um ein Einsetzen in der hier genannten Art zu bewerkstelligen.

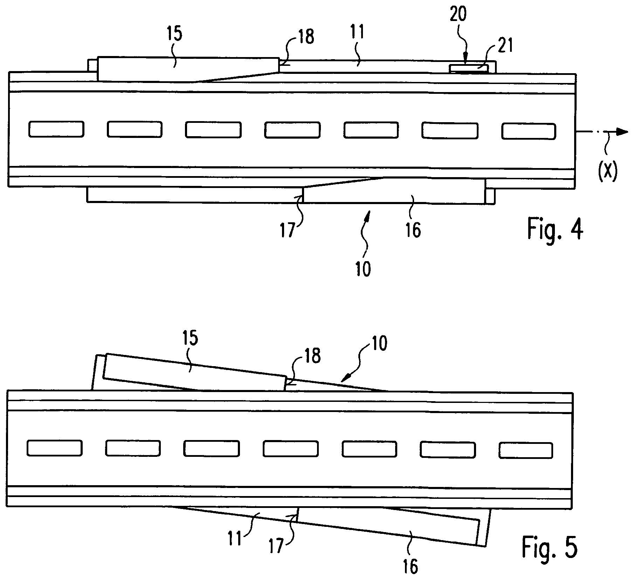

Bei der nachfolgend beschriebenen Ausführungsform sind die obere Halteeinrichtung 15 und die untere Halteeinrichtung 16 rotationssymmetrisch um eine Achse Z ausgebildet, die in der Mitte der Rückwand 11 des Körpers 10 liegt. Diese Ausführungsform der Erfindung unterscheidet sich weiterhin dadurch, dass die obere Halteeinrichtung 15 und die untere Halteeinrichtung 16 jeweils Abschrägungen 19, 19' aufweisen. Dies führt dazu, dass der Abstand zwischen dem Innenende 17 der oberen Halteeinrichtung 15 und dem Innenende 18 der unteren Halteeinrichtung 16 gegenüber der zuvor gezeigten Ausführungsform vergrößert ist, so dass der Drehwinkel, um welchen der Körper 10 zum Einsetzen verdreht werden muss, kleiner wird. Die befestigte Position des Körpers 10 an der Hutschiene 1 ist in Fig. 4 gezeigt, die Position, in welcher der Körper 10 an der Hutschiene 1 befestigt wird, ist in Fig. 5 gezeigt. Aus diesen Abbildungen ist auch sehr gut die Funktion der Abschrägungen 19, 19' zu ersehen.

Fig. 6, 7 zeigen ein Ausführungsbeispiel eines Lüfters 10, der eine Befestigungseinrichtung 26 zum Befestigen an einer Hutschiene 1 aufweist. Die im Zusammenhang mit den Fig. 1-5 beschriebenen Konstruktionsmerkmale und Funktionen der Befestigungseinrichtung werden auch im Zusammenhang mit dem Lüfter gemäß Fig. 6, 7 offenbart.

Der Lüfter 10 weist eine Düse 27 auf. Die Düse 27 ist eine bewegliche Düse, mit der die Richtung des Luftstromes, der aus der Lüfterdüse 27 austritt, gelenkt werden kann. Die Düse 27 ist um eine Achse schwenkbar, die im befestigen Zustand parallel zu der Längsachse der Hutschiene 1 (nicht dargestellt) verläuft. Die Düse 27 ist an einer Grundplatte 25 befestigt. Die Verbindung zwischen der Düse 27 und der Grundplatte 25 erfolgt durch ein an sich bekanntes eindimensionales Schwenkelement bzw. Schwenkgelenk (nicht dargestellt). Ein eindimensionales Schwenkelement ist in einer einzigen Schwenkebene verschwenkbar.

Die konvex gekrümmte Rückwand der Düse 27 ist in einer entsprechend konkav gekrümmten Vorderwand der Grundplatte 25 aufgenommen. Die Seitenwände der Grundplatte 25 weisen Luftschlitze 30 auf. Weitere Luftschlitze sind in der Vorderwand der Grundplatte 25 sowie in der Rückwand der Düse 27 vorgesehen. Für die Düse 27 und die Grundplatte 25 können an sich bekannte Bauteile verwendet werden, wobei die Rückwand der Grundplatte 25 eine Befestigungseinrichtung 26 aufweist, die die Verbindung der Grundplatte 25 mit einer Hutschiene 1 durch eine seitliche Kippbewegung ermöglicht. Dazu weist die Befestigungseinrichtung 26, wie am besten in Fig. 7 zu sehen, obere und untere Halteeinrichtungen 15', 15" und 16', 16" auf. Der Aufbau der Halteeinrichtungen 15', 15" und 16', 16" entspricht im Wesentlichen dem Aufbau der Halteeinrichtung gemäß Fig. 1-5, auf die an dieser Stelle explizit Bezug genommen wird.

Um den Lüfter in zwei verschiedenen Positionen an der Hutschiene 1 befestigen zu können, sind mehrere obere Halteeinrichtungen 15', 15' und mehrere untere Halteeinrichtungen 16', 16" vorgesehen, die jeweils unterschiedlich orientiert sind, d.h. die oberen Halteeinrichtungen 15', 15" weisen unterschiedliche Längsrichtungen auf. Die unteren Halteeinrichtungen 16', 16" weisen ebenfalls unterschiedliche Längsrichtungen auf. In derselben Längsrichtung parallel ausgerichtete obere und untere Halteeinrichtungen 15', 15" bzw. 16', 16" bilden jeweils ein Haltepaar zur Befestigung des Lüfters 10 an der Hutschiene 1. Aus der unterschiedlichen Orientierung der Haltepaare ergeben sich die unterschiedlichen Montagepositionen des Lüfters 10.

Konkret weist der Lüfter 10 gemäß Fig. 6, 7 zwei obere Halteeinrichtungen 15', 15" und zwei untere Halteeinrichtungen 16', 16" auf. Jeweils eine obere Halteeinrichtungen 15' und eine untere Halteeinrichtung 16' bzw. 16" wirken paarweise zum Befestigen des Lüfters 10 an der Hutschiene 1 zusammen. Im Beispiel gemäß Fig. 6 sind die beiden oberen Halteeinrichtungen 15', 15" unter einem Winkel von 90° zueinander ausgerichtet. Dasselbe gilt für die beiden unteren Halteeinrichtungen 16', 16". Dadurch ergeben sich zwei um 90° verdrehte Montagepositionen für den Lüfter. Andere Ausrichtwinkel zwischen den beiden oberen Halteeinrichtungen 15', 15" bzw. den beiden unteren Halteeinrichtungen 16', 16" sind möglich. Dadurch ergeben sich entsprechend unterschiedliche Montagepositionen. Die Ausrichtwinkel der oberen und unteren Halteeinrichtungen 15', 15" bzw. 16', 16" entsprechen einander, damit die für die Befestigung an der Hutschiene erforderliche Parallelität der einzelnen Halteeinrichtungen 15', 15" bzw. 16', 16" erhalten bleibt. Das Erfordernis der Parallelität bedeutet, dass die beiden Halteeinrichtungen 15', 16' bzw. 15", 16" eines Haltepaares parallel zueinander verlaufen, damit diese den oberen und unteren Rand 2, 3 der Hutschiene 1 umgreifen können.

Der Lüfter 27 umfasst ein Ausblasgitter 35, das an der der Rückwand 11 abgewandten Seite des Lüfters 27 angeordnet ist. Durch das Ausblasgitter 35 strömt die Luft. Das Ausblasgitter 35 lässt sich um eine Achse, die im Wesentlichen parallel zur Längsachse des Lüfters 27 verläuft, drehen. Hierdurch kann die Ausströmrichtung der Luft entsprechend verändert bzw. eingestellt werden.

Wie ferner in Fig. 7 gut zu erkennen, sind die Halteeinrichtungen 15', 16' bzw. 15", 16" jeweils eines Haltepaares im befestigten Zustand in Längsrichtung der Hutschiene versetzt zueinander angeordnet. Diese Anordnung der Halteeinrichtungen 15', 16' bzw. 15", 16" entspricht der in den Fig. 1-5 ausführlich erläuterten Anordnung. Dasselbe gilt für den Abstand b zwischen dem jeweiligen Innenende 17', 17" der beiden oberen Halteeinrichtungen 15', 15" und den Innenenden 18', 18" der beiden unteren Halteeinrichtungen 16', 16". Der Abstand d zwischen den jeweils zugehörigen Innenenden 17', 18' bzw. 17", 18" eines Haltepaares ist größer als der Abstand b zwischen dem Oberrand 2 und dem Unterrand 3 der Hutschiene 1 (nicht dargestellt). Dadurch ist der Lüfter 10 durch Kippen in einer Einsetzkipprichtung k um eine Kippachse Z senkrecht zur Hutschienenlängsrichtung X in die Hutschiene 1 einsetzbar. Zur Lage der vorgenannten Achsen bzw. Richtungen wird auf die Fig. 1-5 verwiesen.

Zur Positionssicherung des Lüfters 10 im befestigten Zustand sind zwei Sperrriegel 20', 20" vorgesehen, die die Arretierung der Grundplatte 25 in der jeweils gewählten Position ermöglichen. Der Sperrriegel 20' ist mit einem der beiden Haltepaare 17", 18" ausgerichtet und fluchtet mit einer der beiden oberen Halteeinrichtungen 15". Der weitere Sperrriegel 20' ist mit dem anderen Haltepaar ausgerichtet und fluchtet mit der entsprechend anderen oberen Halteeinrichtung 15'. Die beiden Sperrriegel 20', 20" weisen jeweils eine Federplatte 20 auf, die beim Einsetzen des Lüfters 10 in die Hutschiene 1 ausgelenkt und in der Halteposition des Lüfters 10 in die Ruhelage zurückfedern. Dabei übergreift der Sperrriegel 20' bzw. 20" den Oberrand bzw. Unterrand 2, 3 der Hutschiene 1. Damit ist der Lüfter 10 in der Hutschiene 1 arretiert. Zum einfachen Einsetzen weisen die beiden Sperrriegel 20', 20" jeweils eine Schrägfläche 21 auf, entlang der der Oberrand bzw. Unterrand 2, 3 der Hutschiene 1 gleitet. Die Arretierung erfolgt entlang der Haltefläche 24, die an der Unterseite des Sperrriegels 20' bzw. 20" ausgebildet ist und die im befestigten Zustand den Oberrand bzw. Unterrand 2, 3 übergreift. Zum Lösen des Sperrriegels 20', 20" ist eine Betätigungsplatte 23 vorgesehen, die sich über das Gehäuse bzw. die Grundplatte 25 hinaus erstreckt und seitlich zugänglich ist. Durch die Betätigungsplatte 23 kann die Federplatte 22 ausgelenkt werden, so dass der Oberrand bzw. Unterrand 2, 3 von dem Sperrriegel 20', 20" bzw. der zugehörigen Haltefläche 24 freikommen. Der Lüfter kann dann durch eine der Einsetzkipprichtung k entgegengesetzte Kippbewegung aus der Hutschiene 1 gelöst werden.

Die Federplatte 22 ist Teil der Rückwand 11 der Grundplatte 25, wobei die Federfunktion durch zwei Parallelschlitze erreicht wird, die die Federplatte 22 abschnittsweise von der Rückwand 11 trennen. Die Schlitze verlaufen parallel zur Haltefläche 24.

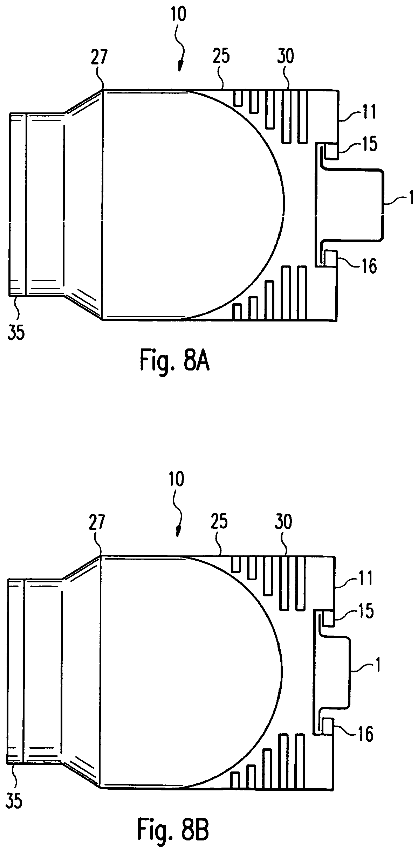

Fig. 8A und 8B zeigen schematische Seitenansichten verschiedener Arten von Hutschienen 1. Die Hutschiene 1 kann verschiedene Formate aufweisen. Insbesondere finden zwei gängige Hutschienenformate bzw. Arten von Hutschienen Anwendung im Schaltschrankbau. Die Hutschienenformate unterscheiden sich hinsichtlich der Tiefe der Hutschiene 1 und hinsichtlich der Dicke, d.h. des Durchmessers, des Materials der Hutschiene 1 selbst. In Fig. 8A weist die Hutschiene 1 im Vergleich zur Hutschiene 1 in Fig. 8B eine größere Tiefe auf (in Fig. 8A bzw. Fig. 8B ist dies die Ausdehnung der Hutschiene 1 von links nach rechts). Das Material der Hutschiene 1 in Fig. 8B hat einen kleineren Durchmesser, d.h. eine geringere Dicke, im Vergleich zur Hutschiene 1 in Fig. 8A.

Abhängig von dem Format bzw. der Art der Hutschiene 1, an der der Lüfter 27 befestigt werden bzw. befestigbar sein soll, sind die Halteeinrichtungen 15, 16 und insbesondere die Abschrägungen 19, 19' entsprechend ausgebildet. Da insbesondere zwei Hutschienenformate gängiger Standard im Schaltschrankbau sind, sind die Halteeinrichtungen 15, 16 und/oder die Abschrägungen 19, 19' des Lüfters 27 abhängig davon, an welchem Hutschienenformat bzw. an welcher Art von Hutschiene 1 der Lüfter 27 befestigt werden bzw. befestigbar sein soll, entsprechend ausgebildet bzw. angepasst.

### Bezugszeichenliste

- 1: Hutschiene
- 2: Oberrand
- 3: Unterrand
- 10: Gerät/Körper
- 11: Rückwand
- 12: Oberseite
- 13: linke Seite
- 13': rechte Seite
- 14: Unterseite
- 15: obere Halteeinrichtung
- 16: untere Halteeinrichtung
- 17: Innenende oben
- 18: Innenende unten
- 19, 19': Abschrägung
- 20', 20": Sperrriegel
- 21: Schrägfläche
- 22: Federplatte
- 23: Betätigungsplatte
- 24: Haltefläche
- 25: Grundplatte
- 26: Befestigungseinrichtung
- 27: Düse
- 30: Luftschlitze
- 35: Ausblasgitter
- X: Längsrichtung
- d: Abstand Innenenden
- b: Breite Hutschiene
- Z: Kippachse
- k: Kipprichtung

## Patentansprüche

1. Lüfter mit einer Düse (27), die an einer Grundplatte (25) befestigt ist, wobei die Grundplatte (25) an ihrer Rückwand (11) eine Befestigungseinrichtung (26) mit wenigstens einer oberen Halteeinrichtung (15) und wenigstens einer unteren Halteeinrichtung (16) zum Befestigen des Lüfters (10) an einer Hutschiene (1) aufweist,
**dadurch gekennzeichnet, dass**
die obere Halteeinrichtung (15) und die untere Halteeinrichtung (16) im befestigten Zustand einen Oberrand (2) bzw. einen Unterrand (3) der Hutschiene (1) umgreifen und versetzt zueinander angeordnet sind in einer Richtung, die im befestigten Zustand des Lüfters (10) parallel zur Längsachse der Hutschiene (1) verläuft, wobei die in dieser Richtung aufeinander zugewandten Enden der Halteeinrichtungen (15, 16) Innenenden (17, 18) bilden, und zwischen dem Innenende (17) der oberen Halteeinrichtung (15) und dem Innenende (18) der unteren Halteeinrichtung (16) ein Abstand (d) von einer Breite liegt, die größer ist als der Abstand (b) zwischen dem Oberrand (2) und dem Unterrand (3) der Hutschiene (1), so dass der Lüfter (10) durch Kippen in einer Einsetzkipprichtung (k) um eine Kippachse (Z) senkrecht zu einer Hutschienenlängsrichtung (X) in die Hutschiene (1) einsetzbar ist,
wobei die Düse (27) mit der Grundplatte (25) durch ein eindimensionales Schwenkelement zum Verschwenken des Lüfters (10) um eine Schwenkachse verbunden ist, wobei die Rückwand der Düse konvex gekrümmt und in einer entsprechend konkav gekrümmten Vorderwand der Grundplatte (25) aufgenommen ist, und wobei die Seitenwände und die Vorderwand der Grundplatte (25) und die Rückwand der Düse (27) Luftschlitze aufweisen.

2. Lüfter nach Anspruch 1,
**dadurch gekennzeichnet, dass**
die obere und die untere Halteeinrichtung (15, 16) einander zugewandte Abschrägungen (19, 19') zur Verminderung eines zum Einsetzen notwendigen Kippwinkels aufweisen.

3. Lüfter nach Anspruch 1 oder 2,
**dadurch gekennzeichnet, dass**
die obere und die untere Halteeinrichtung (15, 16) im Wesentlichen rotationssymmetrisch um die Kippachse ausgebildet sind.

4. Lüfter nach einem der vorhergehenden Ansprüche,
**dadurch gekennzeichnet, dass**
die Halteeinrichtungen (15, 16) mit der Rückwand (11) einstückig ausgebildet, insbesondere aus Kunststoff, vorzugsweise spritzgegossen sind.

5. Lüfter nach einem der vorhergehenden Ansprüche,
**dadurch gekennzeichnet, dass**
die Befestigungseinrichtung (26) mehrere obere Halteeinrichtungen (15', 15") und mehrere untere Halteeinrichtungen (16', 16") aufweist, wobei die oberen und die unteren Halteeinrichtungen (15', 15"; 16', 16") unterschiedlich orientiert sind und paarweise zum Befestigen des Lüfters (10) an der Hutschiene (1) derart zusammenwirken, dass der Lüfter (10) in unterschiedlichen Positionen montierbar ist.

6. Lüfter nach einem der vorhergehenden Ansprüche,
**dadurch gekennzeichnet, dass**
der Lüfter (10) in derartigen Positionen montierbar ist, dass die Schwenkachse im Wesentlichen parallel oder im Wesentlichen senkrecht zur Längsachse der Hutschiene (1) verläuft.

7. Lüfter nach einem der vorhergehenden Ansprüche,
**gekennzeichnet durch**
einen Sperrriegel (20), der das Gerät (10) im befestigten Zustand gegen das Kippen sperrt.

8. Lüfter nach Anspruch 7,
**dadurch gekennzeichnet, dass**
der Sperrriegel (20) beim Einsetzen des Gerätes (10) durch das Kippen in Einsetzkipprichtung entsperrbar ist.

9. Lüfter nach einem der vorhergehenden Ansprüche, insbesondere nach einem der Ansprüche 2-8,
**dadurch gekennzeichnet, dass**
die Halteeinrichtungen (15, 16) und/oder die Abschrägungen (19, 19') auf die Materialdicke der Hutschiene (1) und/oder die Tiefe der Hutschiene (1) angepasst sind.

10. Anordnung aufweisend einen Lüfter (10) nach einem der Ansprüche 1-9, und eine Hutschiene (1), wobei der Lüfter (10) durch die Befestigungseinrichtung (26) mit der Hutschiene (1) verbunden ist.

## Claims

1. Fan with a nozzle (27) which is fastened on a base plate (25), wherein the base plate (25), on its rear wall (11), has a fastening device (26) with at least one upper retaining device (15) and at least one lower retaining device (16) for fastening the fan (10) on a top-hat rail (1),
**characterized in that**
the upper retaining device (15) and the lower retaining device (16), in the fastened state, engage around an upper periphery (2) and a lower periphery (3), respectively, of the top-hat rail (1) and are offset in relation to one another in a direction which, in the fastened state of the fan (10), runs parallel to the longitudinal axis of the top-hat rail (1), wherein those ends of the retaining devices (15, 16) which are directed toward one another in this direction form inner ends (17, 18), and the inner end (17) of the upper retaining device (15) and the inner end (18) of the lower retaining device (16) are spaced apart by a distance (d) of a width which is greater than the distance (b) between the upper periphery (2) and the lower periphery (3) of the top-hat rail (1), and therefore the fan (10) can be inserted into the top-hat rail (1) by being tilted in a direction of tilting insertion (k) about a tilting axis (Z) perpendicular to a longitudinal direction (X) of the top-hat rail, wherein the nozzle (27) is connected to the base plate (25) by a one-dimensional pivoting element for pivoting the fan (10) about a pivot axis, wherein the rear wall of the nozzle is convexly curved and accommodated in a correspondingly concavely curved front wall of the base plate (25), and wherein the side walls and the front wall of the base plate (25) and the rear wall of the nozzle (27) have air slots.

2. Fan according to Claim 1,
**characterized in that**
the upper and the lower retaining devices (15, 16) have bevels (19, 19') which are directed toward one another and are intended for reducing a tilting angle which is necessary for insertion purposes.

3. Fan according to Claim 1 or 2,
**characterized in that**
the upper and the lower retaining devices (15, 16) are designed to be essentially rotationally symmetrical about the tilting axis.

4. Fan according to one of the preceding claims, **characterized in that**
the retaining devices (15, 16) are formed in one piece with the rear wall (11), in particular from plastic, preferably by being injection-molded.

5. The fan according to one of the preceding claims,
**characterized in that**
the fastening device (26) has a plurality of upper retaining devices (15', 15") and a plurality of lower retaining devices (16', 16"), wherein the upper and the lower retaining devices (15', 15"; 16', 16") are oriented differently and interact in pairs for fastening the fan (10) on the top-hat rail (1) such that the fan (10) can be installed in different positions.

6. Fan according to one of the preceding claims, **characterized in that**
the fan (10) can be installed in such positions that the pivot axis runs essentially parallel, or essentially perpendicularly, to the longitudinal axis of the top-hat rail (1).

7. Fan according to one of the preceding claims, **characterized by**
a locking catch (20), which locks the apparatus (10) against tilting in the fastened state.

8. Fan according to Claim 8,
**characterized in that**
the locking catch (20) can be unlocked upon insertion of the apparatus (10) by the latter being tilted in the direction of tilting insertion.

9. Fan according to one of the preceding claims, in particular according to one of Claims 2-8, **characterized in that**
the retaining devices (15, 16) and/or the bevels (19, 19') are adapted to the material thickness of the top-hat rail (1) and/or the depth of the top-hat rail (1).

10. Arrangement having a fan (10) according to one of Claims 1-9 and having a top-hat rail (1), wherein the fan (10) is connected to the top-hat rail (1) by the fastening device (26).

## Revendications

1. Ventilateur comprenant une buse (27) qui est fixée à une plaque de base (25), la plaque de base (25) comprenant, sur sa paroi arrière (11), un dispositif de fixation (26) doté d'au moins un dispositif de retenue supérieur (15) et d'au moins un dispositif de retenue inférieur (16) servant à fixer le ventilateur (10) sur un profilé chapeau (1), **caractérisé en ce que**
le dispositif de retenue supérieur (15) et le dispositif de retenue inférieur (16) viennent en prise, à l'état fixé, autour d'un bord supérieur (2), respectivement d'un bord inférieur (3), du profilé chapeau (1) et sont disposés de manière décalée l'un par rapport à l'autre dans une direction qui s'étend parallèlement à l'axe longitudinal du profilé chapeau (1) à l'état fixé du ventilateur (10), les extrémités, tournées l'une vers l'autre dans cette direction, des dispositifs de retenue (15, 16) formant des extrémités intérieures (17, 18), et une distance (d) égale à une largeur étant située entre l'extrémité intérieure (17) du dispositif de retenue supérieur (15) et l'extrémité intérieure (18) du dispositif de retenue inférieur (16), laquelle distance est supérieure à la distance (b) entre le bord supérieur (2) et le bord inférieur (3) du profilé chapeau (1), de telle sorte que le ventilateur (10) puisse être inséré dans le profilé chapeau (1) par basculement dans une direction de basculement d'insertion (k) autour d'un axe de basculement (Z) perpendiculaire à une direction longitudinale de profilé chapeau (X),
la buse (27) étant reliée à la plaque de base (25) au moyen d'un élément de pivotement unidimensionnel servant au pivotement du ventilateur (10) autour d'un axe de pivotement, la paroi arrière de la buse étant de courbure convexe et étant logée dans une paroi avant, de courbure concave correspondante, de la plaque de base (25), et les parois latérales et la paroi avant de la plaque de base (25) et la paroi arrière de la buse (27) comprenant des fentes d'aération.

2. Ventilateur selon la revendication 1,
**caractérisé en ce que**
le dispositif de retenue supérieur et le dispositif de retenue inférieur (15, 16) comprennent des biseaux (19, 19'), tournés l'un vers l'autre, servant à réduire un angle de basculement nécessaire pour l'insertion.

3. Ventilateur selon la revendication 1 ou 2, **caractérisé en ce que**
le dispositif de retenue supérieur et le dispositif de retenue inférieur (15, 16) sont sensiblement à symétrie de révolution autour de l'axe de basculement.

4. Ventilateur selon l'une des revendications précédentes,
**caractérisé en ce que**
les dispositifs de retenue (15, 16) sont formés d'un seul tenant avec la paroi arrière (11), en particulier à partir de matière synthétique, de préférences sont moulés par injection.

5. Ventilateur selon l'une des revendications précédentes,
**caractérisé en ce que**
le dispositif de fixation (26) comprend plusieurs dispositifs de retenue supérieurs (15', 15") et plusieurs dispositifs de retenue inférieurs (16', 16"), les dispositifs de retenue supérieurs et les dispositifs de retenue inférieurs (15', 15" ; 16', 16") étant orientés différemment et coopérant par paires pour fixer le ventilateur (10) au profilé chapeau (1) de telle sorte que le ventilateur (10) puisse être monté en différentes positions.

6. Ventilateur selon l'une des revendications précédentes,
**caractérisé en ce que**
le ventilateur (10) peut être monté dans des positions telles que l'axe de pivotement s'étende sensiblement parallèlement ou sensiblement perpendiculairement à l'axe longitudinal du profilé chapeau (1).

7. Ventilateur selon l'une des revendications précédentes,
**caractérisé par**
un verrou de blocage (20) qui bloque l'appareil (10) à l'état fixé de manière à empêcher le basculement.

8. Ventilateur selon la revendication 7,
**caractérisé en ce que**
le verrou de blocage (20) peut être débloqué lors de l'insertion de l'appareil (10) par le basculement dans la direction de basculement d'insertion.

9. Ventilateur selon l'une des revendications précédentes, en particulier selon l'une des revendications 2 à 8,
**caractérisé en ce que**
les dispositifs de retenue (15, 16) et/ou les biseaux (19, 19') sont adaptés à l'épaisseur de matériau du profilé chapeau (1) et/ou à la profondeur du profilé chapeau (1).

10. Ensemble comprenant un ventilateur (10) selon l'une des revendications 1 à 9 et un profilé chapeau (1), le ventilateur (10) étant relié au profilé chapeau (1) au moyen du dispositif de fixation (26).
